(19) **Europäisches Patentamt**

**European Patent Office**

**Office européen des brevets**

(11) **EP 1 681 750 A1**

(12) **EUROPEAN PATENT APPLICATION**

(43) Date of publication:
19.07.2006 Bulletin 2006/29

(51) Int Cl.:
*H01S 3/0941* (2006.01)     *H01S 3/06* (2006.01)
*H01S 3/102* (2006.01)

(21) Application number: 06000490.0

(22) Date of filing: 11.01.2006

(84) Designated Contracting States:
**AT BE BG CH CY CZ DE DK EE ES FI FR GB GR
HU IE IS IT LI LT LU LV MC NL PL PT RO SE SI
SK TR**
Designated Extension States:
**AL BA HR MK YU**

(30) Priority: **17.01.2005 JP 2005008570**

(71) Applicant: **FANUC LTD
Minamitsuru-gun,
Yamanashi 401-0597 (JP)**

(72) Inventors:
• **Machida, Hisatada,
c/o FANUC
Minamitsuru-gun
Yamanashi 401-0511 (JP)**

• **Nishikawa, Yuji,
c/o FANUC
Minamitsuru-gun
Yamanashi 401-0511 (JP)**
• **Miyata, Ryusuke,
c/o FANUC
Minamitsuru-gun
Yamanashi 401-0511 (JP)**

(74) Representative: **Thum, Bernhard
Wuesthoff & Wuesthoff
Patent- und Rechtsanwälte
Schweigerstrasse 2
81541 München (DE)**

(54) **Laser oscillator and method of estimating the lifetime of a pump light source**

(57)     A laser oscillator (100) enabling estimation of the lifetime of the pump light source (10) by a simple configuration, provided with a pump light source (10), a power source (30) supplying current to the pump light source (10), a laser crystal (20) outputting laser light by the pump light emitted from the pump light source (10), a power sensor (40) receiving laser light generated from the laser crystal (20) and outputting a signal corresponding to the intensity of the laser light, a memory (60) storing the operating time of the laser oscillator, and a processor (50) judging if the signal output by the power sensor (40) satisfies a predetermined condition and, if satisfying the predetermined condition, uses the value of the current supplied by the power source (30) to the pump light source (10) and the operating time stored in the memory (60) to estimate the lifetime of the pump light source (10).

EP 1 681 750 A1

**Description**

BACKGROUND OF THE INVENTION

1. Field of the Invention

The present invention relates to a laser oscillator, more particularly relates to a laser oscillator provided with a function of estimating the lifetime of a pump light source and a method of estimating the lifetime of a pump light source of a laser oscillator.

2. Description of the Related Art

In a solid state laser oscillator, in particular a laser oscillator using an Nd:YAG crystal etc. as a laser crystal, a lamp or laser diode or other such consumable is used as the pump light source. Since the light source is a consumable, it has to be periodically replaced. Since the lifetimes are not uniform, however, it is necessary to replace the light source while checking its state of emission. However, measuring the output of a lamp or laser diode in a laser oscillator is difficult. Some sort of indicator for determining the replacement time has therefore been required. In particular, when using a pump light source such as a laser diode with a long replacement period, the protrision of such an indicator would enable the trouble of taking out the pump light source from the laser oscillator and investigating its output to be eliminated. Therefore, the maintenance work at the time of replacement would be greatly facilitated. Further, since the cost of replacement is high, highly accurate estimation of the lifetime would enable originally unnecessary replacement to be eliminated and therefore enable the running costs to be kept low.

The method of measuring the individual light outputs of a laser diode array using photodiodes to investigate the changes in the states of emission over time and estimate the lifetime is disclosed in Japanese Patent Publication (A) No. 2003-298182. However, if applying this method to a kW class high output laser oscillator, since the pump light source used is a laser diode array of a 1000 diodes or so, since a photodetector would be required for each laser diode, the number of parts would greatly increase. Further, the number of currents monitored would also increase, so there would be the problem of a greater increase in cost.

SUMMARY OF THE INVENTION

An object of the present invention is therefore to provide a laser oscillator enabling estimation of the lifetime of the pump light source without taking the pump light source out from the laser oscillator and a method of estimation of the lifetime of a pump light source of a laser oscillator. Another object of the present invention is to provide a laser oscillator enabling highly accurate estimation of the lifetime and a method of estimation of the lifetime of a pump light source of the laser oscillator.

"Highly accurate estimation of lifetime" means the ability to predict even deterioration other than a drop in output. As one example, the case of use of a laser diode as a pump light source will be explained. A laser diode undergoes a shift in wavelength along with a drop in output. On the other hand, most laser crystals pumped by a laser diode have narrow absorption spectrums. A wavelength shift of the laser diode therefore is also a factor causing a drop in the accuracy of estimation of lifetime. By taking out part of the output of a laser diode exhibiting such dual deterioration, it is only possible to measure the drop in output. Therefore, to accurately measure to what extent a laser crystal is actually pumped, a signal based on the laser light generated by the laser crystal is used as an indicator. By using such an indicator, highly accurate estimation of the lifetime becomes possible.

According to a first aspect of the present invention, there is provided a laser oscillator provided with a pump light source, a power source for supplying current to the pump light source, a laser crystal outputting laser light by pump light emitted from the pump light source, a power sensor receiving the laser light generated by the laser crystal and outputting a signal corresponding to the intensity of that laser light, a memory storing the operating time of the laser oscillator, and a processor using the value of the current supplied by the power source to the pump light source and the operating time stored in the memory to estimate the lifetime of the pump light source.

Further, in the laser oscillator according to the present invention, the processor preferably judges whether the signal output from the power sensor satisfies a predetermined condition and estimates the lifetime of the pump light source when satisfying the predetermined condition.

Further, the laser oscillator according to the present invention preferably further has a sub processor which judges whether the signal output from the power sensor satisfies a predetermined condition, and the processor estimates the lifetime of the pump light source when notified by the sub processor of a judgment of the condition being satisfied.

Further, in the laser oscillator according to the present invention, preferably the memory stores the value of the current supplied by the power source to the pump light source at the time of estimation of the lifetime, and the processor estimates the lifetime by finding the estimated lifetime $\tau$ from the relation

$$\tau = ((I_{max} - I)/(I - I^{-m}))^k \, T(m),$$

wherein k is a real number of 0.5 to 1.0 using the value of the current I supplied by the power source to the pump light source when the signal output from the power sensor is judged to satisfy the predetermined condition, a predetermined cumulative operating time $T(m)$ found from the operating time stored in the memory, a value of current $I^{-m}$ supplied to the pump light source at the time of estimation of the lifetime determined based on the cumulative operating time $T(m)$ obtained from the memory, and the value of the maximum rated current $I_{max}$ of the pump light source.

Further, in the laser oscillator according to the present invention, preferably the pump light source has a plurality of sub light sources, and the power source has a plurality of sub power sources supplying current to the plurality of sub light sources.

Further, in the laser oscillator according to the present invention, preferably the memory stores the values of the currents supplied by the sub power sources to the sub light sources at the different times of estimation of the lifetime and the processor estimates the lifetime when judging that the signal output from the power sensor satisfies the predetermined condition by using the value of the current $I_n$ supplied by any sub power source to a sub light source, a predetermined cumulative operating time $T(m)$ found from the operating times stored in the memory, the value of the current $I_n^{-m}$ supplied to the sub light sources at the time of estimation of the lifetime determined based on the cumulative operating time $T(m)$ obtained from the memory, and the value of the maximum rated current $I_{max}$ of the pump light source to find the estimated lifetime $\tau_n$ of the sub light source from the relation:

$$\tau_n = ((I_{max} - I_n)/(I - I_n^{-m}))^k \, T(m)$$

where k is a real number from 0.5 to 1.0.

Further, in the laser oscillator according to the present invention, preferably the predetermined condition is that, both when the method of output of the laser light is continuous or pulse oscillation, the fluctuation of the signal output by the power sensor remains within a predetermined range for a predetermined period.

Further, in the laser oscillator according to the present invention, preferably the predetermined condition is that the output of the laser light be substantially equal to the signal corresponding to a value near the maximum output of the laser oscillator or a predetermined rated output.

Further, the laser oscillator according to the present invention preferably has a display which displays the estimated lifetime of the pump light source estimated by the processor and displays a warning when the estimated lifetime is a predetermined replacement warning standard or less.

According to another aspect of the present invention, there is provided a method of estimation of the lifetime of a pump light source of a laser oscillator having a pump light source, a power source supplying current to the pump light source, a laser crystal outputting laser light by pump light emitted from the pump light source, a power sensor receiving laser light generated from the laser crystal and outputting a signal corresponding to the intensity of that laser light, a memory storing the operating time, and a processor estimating the lifetime of the pump light source, including a step of adjusting the laser light generated by the laser oscillator to a predetermined intensity, a step of measuring the value of the current supplied by the power source to the pump light source when the laser light generated by the laser oscillator is adjusted to the predetermined intensity, and a step of estimating the lifetime of the pump light source based on the current value and the operating time of the laser oscillator.

Note that in the method of estimation of the lifetime of the pump light source of a laser oscillator according to the present invention cf the laser oscillator according to the present invention, in the step of adjusting the laser light to a predetermined intensity, preferably pulse output is used for the method of laser output.

Further, in the method of estimation of the lifetime of the pump light source of the laser oscillator according to the present invention, the memory is designed to further store the value of the current measured at the step of measuring the current value, the step of measuring the current value measures the value of the current I supplied by the power source to the pump light source when the laser light generated by the laser oscillator is adjusted to a predetermined intensity, and the step of estimating the lifetime finds the cumulative operating time $T(m)$ showing the predetermined period during which the laser oscillator was operated from the operating times stored in the memory and uses the value of the current I, the value of the current $I^{-m}$ supplied by the power source to the pump light source measured when the laser light generated by the laser oscillator is adjusted to the predetermined intensity in an operating time of the laser oscillator specified based on the cumulative operating time $T(m)$ stored in the memory, and the value of the maximum

rated current $I_{max}$ of the pump light source to find the estimated lifetime $\tau$ from the relation

$$\tau = ((I_{max} - I)/(I - I^{-m}))^{k} \ T(m)$$

where, k is a real value of 0.5 to 1.0

Further, in the method of estimation of the lifetime of the pump light source of the laser oscillator according to the present invention, preferably, in the step of adjusting to the predetermined intensity, the method of output of the laser is pulse output, and the step of measuring the current value measures the value of the current when the fluctuation of the signal output by the power sensor remains within a predetermined range for a predetermined period. By measuring the value of the current in the state where the output of the laser light is substantially constant and stable, it is possible to estimate the lifetime of the pump light source more accurately. Note that when generating laser light by the pulse method, the signal output by the power sensor means a signal corresponding to the intensity of the laser light measured by the power sensor during output of the laser light or the average output signal in a period of a certain cycle including a period of output of the laser light and an idle period in the same durations.

As explained above, it is possible to obtain a laser oscillator able to estimate the lifetime of the pump light source by a simple configuration. Further, it is possible to accurately estimate the lifetime of the pump light source.

BRIEF DESCRIPTION OF THE DRAWINGS

These and other objects and features of the present invention will become clearer from the following description of the preferred embodiments given with reference to the attached drawings, wherein:

FIG. 1 is a schematic view of the configuration of a laser oscillator according to an embodiment of the present invention;
FIG. 2A is a view of a flow chart of the calculation and display of the lifetime of the laser diode according to an embodiment of the present invention;
FIG. 2B is a view of a flow chart of the calculation and display of the lifetime of the laser diode according to an embodiment of the present invention;
FIG. 3 is a schematic view of the configuration of a laser oscillator according to another embodiment of the present invention;
FIG. 4 is a schematic view of the configuration of a laser oscillator according to another embodiment of the present invention;
FIG. 5 is a schematic view of the configuration of a laser oscillator according to the related art;
FIG. 6A is a view of a flow chart of the calculation and display of the lifetime of the laser diode according to the embodiment shown in FIG. 4; and
FIG. 6B is a view of a flow chart of the calculation and display of the lifetime of the laser diode according to the embodiment shown in FIG. 4.

DESCRIPTION OF THE PREFERRED EMBODIMENTS

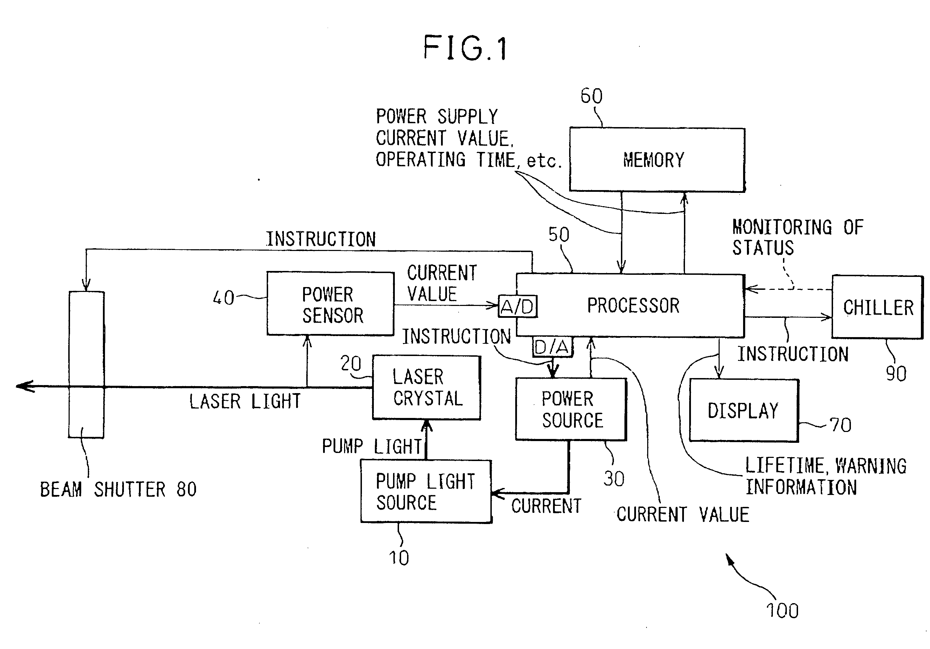

Below, the present invention will be explained in more detail with reference to the drawings.

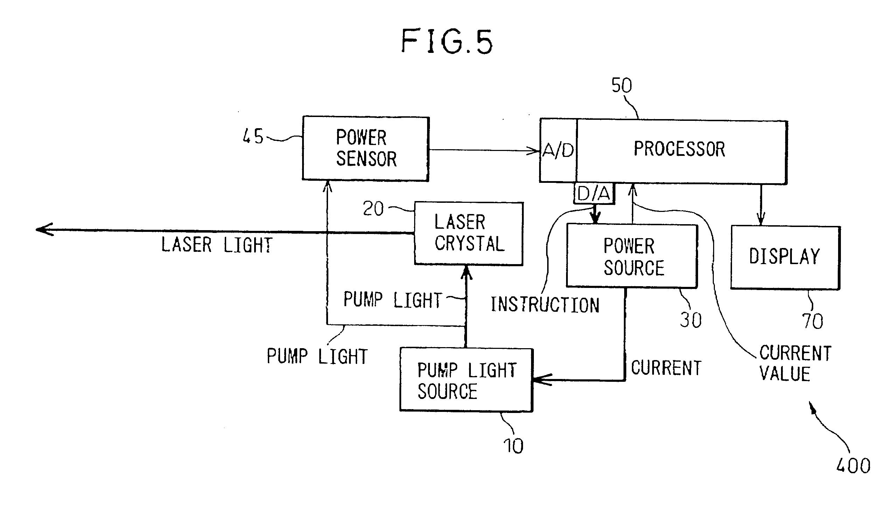

FIG. 5 is a schematic view of the configuration of a laser oscillator 400 of the related art able to estimate the lifetime of the pump light source for comparison with the laser oscillator according to the present invention.
This laser oscillator 400 is comprised of a pump light source 10, laser crystal 20, power source 30, power sensor 45, processor 50, memory 60, display 70, etc. Note that the parts are assigned the same notations as the parts of the laser oscillator according to the present invention explained later. In the laser oscillator 400 according to the related art, when the power source 30 supplies current to the pump light source 10, the pump light source 10 generates pump light and emits it to the laser crystal 20. Further, when the pump light reaches a certain intensity, the laser crystal 20 starts lasering and outputs laser light. On the other hand, unlike the embodiment of the present invention explained later, the power sensor 45 receives part of the pump light and outputs a signal corresponding to that intensity to the processor 50. The processor 50 monitors the intensity signal of the pump light obtained from the power sensor 45 and estimates the remaining lifetime of the pump light source 10 based on the change in intensity of the pump light. The estimated lifetime is sent to the display 70 where it is displayed so that the user can determine the lifetime.
When the pump light source 10 is comprised of a plurality of laser diodes or laser diode arrays, the power sensor 45 has to provide a power sensor for each laser diode in order to investigate the intensity of the pump light emitted from the pump light source 10. Therefore, in the laser oscillator 400 of the related art, the number of parts increases.
On the other hand, FIG. 1 is a schematic view of the configuration of the laser oscillator 100 according to the present embodiment representative of the present invention.

The laser oscillator 100 according to the present embodiment is comprised of a pump light source 10, laser crystal 20, power source 30, power sensor 40, processor 50, memory 60, display 70, beam shutter 80, chiller 90, etc. The functions and typical configurations of these parts will be shown below.

The pump light source 10 is designed to generate a laser by emitting pump light to the laser crystal 20. In this embodiment, as the pump light source 10, a wavelength 0.8 $\mu$m AlGaAs laser diode is used. However, the pump light source 10 used may also be an AlGaInN or AlGaInP laser diode etc. Further, the pump light source 10 emits pump light of an amount of a linear function in relation to the value of the current supplied from the power source 30.

The laser crystal 20 is positioned between facing mirrors (not shown) and uses the pump light emitted from the pump light source 10 to generate a laser between the facing mirrors. Further, the laser crystal 20 is designed to enable the laser light to be taken out through the emission side mirror. As the laser crystal 20, in this embodiment, a neodymium doped yttrium aluminum garnet (Nd:YAG) crystal was used. However, the laser crystal 20 used may also be a neodymium doped yttrium vanadium tetraoxide (Nd:YVO$_4$) crystal, a neodymium doped YLF (Nd:YLF) crystal, a neodymium doped lanthanum scandium borate (Nd:LSB) crystal, an erbium doped YLF (Er:YLF) crystal, a neodymium doped potassium gadolinium tungstate (Nd:KGW) crystal or other laser optical crystal etc.

Note that the laser crystal 20 generates laser light of a wavelength of 1064 nm when using an Nd:YAG crystal. Further, the laser crystal 20 can use a nonlinear optical crystal to generate laser light of a wavelength of 532 nm by generation of the second harmonic or laser light of a wavelength of 355 nm by generation of a third harmonic.

The power source 30 supplies current to the pump light source 10 based on an instruction from the processor 50. The value of the current supplied is designed to be adjustable by operation of a variable resistor provided in the power source 30. Further, the power source 30 is provided with an ammeter (not shown) able to continuously measure the value of the current supplied to the pump light source 10 and sends the processor 50 the measurement value of the supplied current I. However, the power source 30 may also be designed to measure the value of the current I supplied only when receiving an instruction to the effect of measuring the current value from the processor 50. Similarly, it may also be designed to send the value of the measured current I to the processor 50 only when receiving an instruction to the effect of sending the value of the measured current from processor 50. In this case, to prevent a loss in the measurement value even with a time lag from measurement of the current value to transmission to the processor 50, it is preferable to provide a cache memory for temporarily storing the value of the measured current I.

The power sensor 40 is comprised of a photodiode, laser light current measurement circuit, etc. The laser light passing through the emission side mirror is split by a beam splitter (not shown) arranged near the emission side mirror. Further, the photodicde receives part of the split laser light and generates a current in accordance with the intensity of the laser light (below, called "laser light current" tc differentiate it from the current supplied by the power source 30 to the pump light source 10). In this embodiment, the beam splitter is designed to pass 99.5% of the laser light and guide the remaining 0.5% to the photodiode. Further, it is also possible to arrange a filter for further reducing the intensity of the split laser light to about 1% between the beam splitter and the photodiode. By using such a filter, even when the output of the laser light is extremely large, a commercially available photodiode can be used.

The laser light current measurement circuit measures the value of the current generated at the photodiode and sends the measured laser light current value to the processor 50.

The processor 50 is a control unit of the laser oscillator 100 and controls the output of the laser light of the laser oscillator 100. Further, the processor 50 can adjust the output of the laser light of the laser oscillator 100 up to the maximum output. The processor 50 maintains the laser light at a predetermined intensity based on an operation signal from an operating panel (not shown) (turning power source ON/OFF, designating laser light intensity, etc.) and the laser light current measurement value received from the power sensor 40. Alternatively, to change the intensity of the laser light, the power source 30 calculates the value of the current to be supplied to the pump light source 10 based on the laser light current measurement value, converts an instruction based on that calculated value to an analog signal, and sends it to the power source 30.

Further, the processor 50 estimates the lifetime of the laser diode used for the pump light source 10. Here, the estimated lifetime estimated by the processor 50 is the remaining lifetime from the time of estimation of the lifetime to the time when the pump light source 10 has to be replaced. Note that the lifetime of the laser diode is estimated, as explained later, by using the value of the power source current received from the power source 30 when raising the intensity of the laser light to a value near the predetermined maximum output or a predetermined rated output value and the laser light exhibits a predetermined output value, the value of the power source current at a reference point of time, and the cumulative operating time of the laser. Preferably, the lifetime of the laser diode is estimated when calibrating the laser oscillator 100.

Further, the estimated lifetime satisfies a predetermined condition, the processor 50 sets information warning of the need for replacement of the pump light source 10.

Further, the processor 50 informs the user of the laser light intensity, the estimated lifetime of the laser diode used for the pump light source 10, etc. by transmitting this information to the display 70.

The memory 60 stores the operating time at the time of each operation, the value of the current supplied from the power source to the pump light source at each time of estimation of the lifetime, the value of the maximum rated current of the pump light source, the value of the laser light current corresponding to the rated output of the laser oscillator, etc. Further, the memory 60 sends these values to the processor 50 in response to callup requests from the processor 50. Further, it stores values received from the processor 50 in accordance with requests for update from the processor 50 instead of the values previously stored.

The display 70 displays information received from processor 50 such as the estimated lifetime of the pump light source and a warning for replacement of the pump light source.

In this embodiment, the processor 50, memory 60, and display 70 are configured as a personal computer and monitor designed to be able to communicate with the laser oscillator. However, the processor 50, memory 60, and display 70 may also be a processing unit, memory, liquid crystal display panel, etc. of types built into the laser oscillator.

The beam shutter 80 is provided with a damper for absorbing the laser light and a reflection member for changing the direction of emission of the laser light. Further, the beam shutter 80 is arranged on the path of the laser light emitted from the laser crystal 20. By enabling the damper and reflection member to be extended and retracted, the emission and suspension of the laser light and the direction of progression are controlled based on a control signal from the processor 50.

The chiller 90 is provided to maintain the laser oscillator 100 according to the present invention at a constant temperature and is designed to circulate cooling water to a channel arranged in proximity to the pump light source 10 and laser crystal 20. Further, the chiller 90 is provided with a flow meter for measuring the flow rate of the cooling water and a thermometer for measuring the water temperature of the cooling water and transmits the flow rate and temperature of the cooling water measured during the operation of the laser oscillator 100 to the processor 50. Further, the chiller 90 controls the flow rate of the cooling water so as to maintain the temperature of the laser escillator 100 constant based on an instruction received from the processor 50.

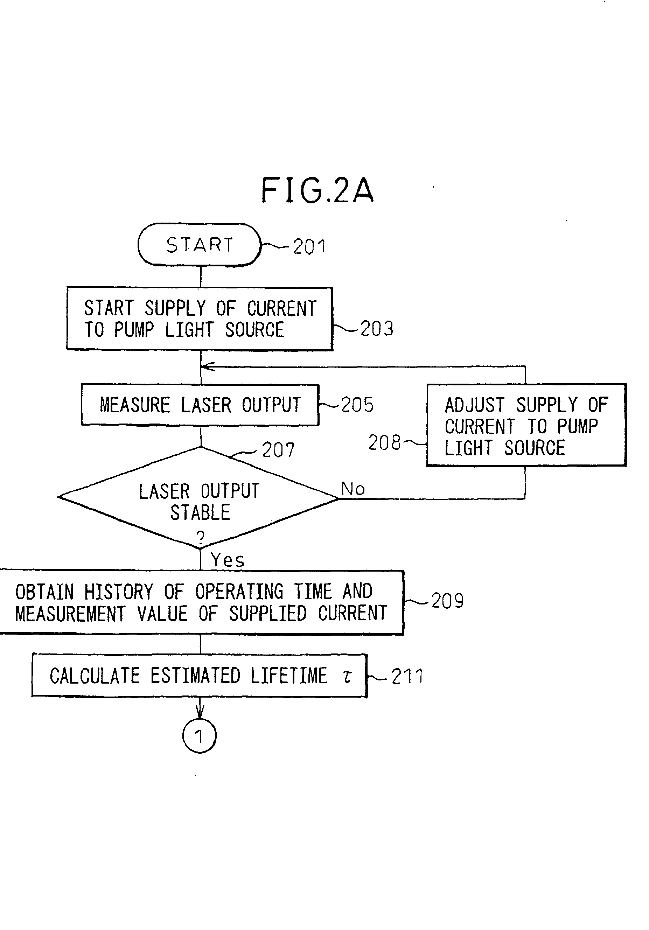

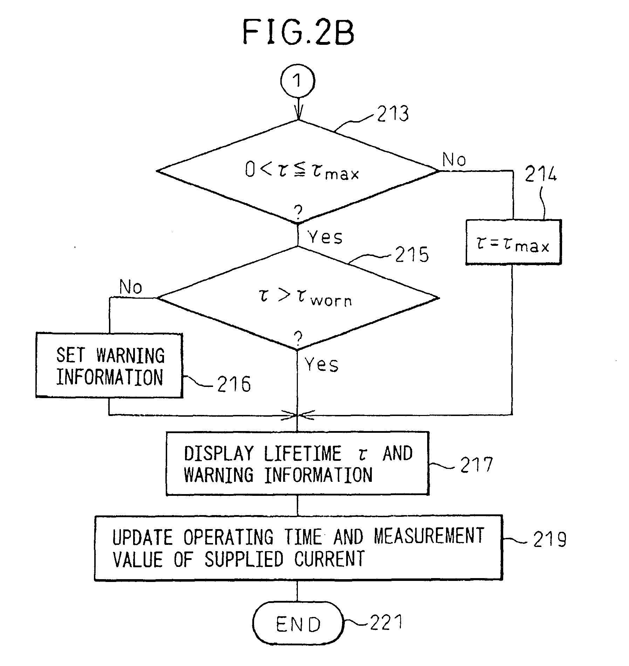

FIG. 2A and FIG. 2B are flow charts of the lifetime estimating routine of a laser diode used for the pump light source 10.

Note that the lifetime estimating routine according to the present invention is executed using a program stored in advance in the processor 50. However, the lifetime estimating routine is not limited to being run using a program and may also be run using firmware or hardware.

The lifetime is estimated when calibrating the laser oscillator 100. In this case, the lifetime is estimated once a month or several times a year. Further, the lifetime can also be estimated at each time of operation. If estimating the lifetime at each time of operation, it is possible to estimate the lifetime by the following routine by the operation of raising the output of the laser light to a predetermined rated output once when starting up the laser oscillator 100.

First, an operating panel (not shown) is used to input a signal to turn on the power to the processor 50, whereby the estimation of the lifetime is started (step 201).

Next, the processor 50 controls the power source 30 to start the supply of current to the pump light source 10 so that the laser oscillator generates a predetermined rated output laser light (step 203). Specifically, the processor 50 sends an instruction to the power source 30 so as to supply current to the pump light source 10 so as to make it generate the pump light required for obtaining the rated output laser light. The system of laser output at this step is preferably the pulse system. The power source 30 supplies current to the pump light source 10 based on the instruction received from the processor 50. When the pump light source 10 starts being supplied with current, the pump light source 10 generates pump light having an intensity of a linear function in relation to the supplied current and emits it to the laser crystal 20. The laser crystal 20 starts lasering and outputs laser light when the pump light reaches a predetermined intensity or more.

When the output of the laser light is started, the output of the laser light is measured (step 205). Part of the laser light is guided via a beam splitter arranged near the emission side mirror of the laser crystal to the photodiode of the power sensor 40. When the photodiode receives the laser light, it generates a laser light current substantially proportional to the intensity of the laser light received. The measurement value of this current $I_o$ is found by a laser light current measurement circuit and sent to the processor 50.

The processor 50 judges whether the output of the laser light is stable by comparing the measurement value of the current $I_o$ corresponding to the laser light against the value of the current $I_F$ corresponding to the rated output of the laser light obtained from the memory 60 (step 207).

This judgment can be performed by investigating if the value of the laser light current $I_o$ received from the power sensor 40 over a predetermined time, for example, a time interval of one second or 10 seconds, is substantially equal to the value of the current $I_F$ corresponding to the rated output, that is, if the value of the laser light current $I_o$ remains within a predetermined range from the value of the current $I_F$ corresponding to the rated output (for example, when the scope of fluctuation is less than 1% of the value of the current $I_F$ corresponding to the rated output). When the value of the laser light current $I_o$ remains within a certain range for a predetermined time, the processor 50 judges that the laser oscillator 100 is stably generating the rated output laser light. Note that the value of the current $I_F$ is fetched during the initial setup procedure of the laser oscillator and stored in the memory 60 (not shown).

When the judgment at step 207 results in the laser light output being judged not stable, the power supplied to the pump light source 10 is adjusted (step 208). When the measurement value $I_o$ is lower than the value of the current $I_F$ corresponding to the rated output, the processor 50 sends the power source 30 an instruction to increase the supplied current. Conversely, when above the value of the current $I_F$ corresponding to the rated output, the processor 50 sends the power source 30 an instruction to reduce the supplied current. Mote that when the measurement value matches with the value of the current $I_F$ corresponding to the rated output, the processor 50 sends the power source 30 an instruction to maintain the amount of the supplied current as it is. Further, the rated output is preferably near the maximum output of the laser oscillator according to the present invention. This is because near the maximum output, the output of the pump light source 10 itself becomes larger to a certain extent, so the difference between the supplied current when the pump light source 10 is deteriorated and when it is not also becomes relatively larger and the deterioration can be easily and accurately detected.

When judging that the laser oscillator 100 is stably generating the rated output laser light, the processor 50 calls up from the memory 60 the operating times $T_1$, $T_2$,..., $T_q$ at the times of operation up to q times before the previous time, the values $I_1$, $I_2$,..., $I_p$ of the current supplied at the time of generation of the rated output up to p times before the previous time (that is, when generating the rated output only at the time of calibration, at the times of calibration up to p times before, while when generating the rated output at the times of operation, at the times of operation up to p times before), and the value of the maximum rated current $I_{max}$ (step 209). Further, it uses the operating times $T_1$, $T_2$,..., Tq at the times of operation to add the operating times at the times of estimation of lifetime up to m times before the time of previous operation and calculate the cumulative operating time T(m). Provided that, m≤q.

Note that the m may be a preset value or may be made a variable value so that the cumulative operating time T(m) becomes a constant range. When the value of m is preset, it is preferable to set it so that the cumulative operating time falls in a range of 500 to 2000 hours considering the average operating time per operation, the calibration cycle, etc. For example, assume that the lifetime is estimated only at the time of calibration performed once a month. If the average operating time per operation of the laser oscillator 100 is 10 hours and the oscillator is operated 20 days a month, the cumulative operating time of the laser oscillator per month would be 200 hours. Therefore, m is preferably set to a value of about 3 to 10. If setting the value of m below the range, the time interval from the reference time to the time of estimation of the lifetime would become too short. Therefore, the degree of deterioration of the laser diode during that interval would be small and the possibility of inclusion of measurement error would become higher. As a result, the accuracy of estimation of the lifetime would become poor. Conversely, if set over the range, there is a possibility that the advance in deterioration of the laser diode used for a relatively long time would not be able to be suitably caught. Further, when making m a variable value, the processor 50 successively increases m by "1" until the cumulative operating time T(m) becomes a preset threshold value $T_{thd}$ or more. The threshold value $T_{thd}$ of the cumulative operating time is similarly preferably set to about 500 hours to 2000 hours so as to prevent the accuracy of estimation of the lifetime from becoming poor.

Next, the processor 50 uses the cumulative operating time T(m), the value of the power source current $I^{-m}$ m times before, the value of the maximum rated current $I_{max}$, and the value of the current I supplied to the pump light source 10 at the present time to estimate the lifetime (step 211).

The estimated lifetime τ is calculated by the following equation:

[Equation 1]

$$\tau = \frac{(I_{max} - I)}{(I - I^{-m})} T(m) \qquad (1)$$

Here, the value of the maximum rated current $I_{max}$ can be set to the value of the maximum rated current determined by the specifications of the laser diode or a value of a current corresponding to the maximum rated output of the laser diode at the time of shipment. If equation (1) is used, complicated calculations are not performed and the lifetime can be estimated simply.

Further, the laser diode tends to finally sharply deteriorate. To reflect this tendency in the calculation of the lifetime, at step 211, instead of equation (1), it is also possible to use the following equation to calculate the estimated lifetime τ.

[Equation 2]

$$\tau = \frac{(I_{max} - I)^k}{(I - I^{-m})^k} T(m) \qquad (2)$$

Here, k, by experience, is preferably 0.5 to less than 1.

Further, a laser diode tends to increase in speed of deterioration along with the accumulation of conduction time. To reflect this tendency in estimation of the lifetime, the value of k is preferably reduced along with the increase in the total conduction time from the time of the start of use of the laser diode. For example, it is possible to set k to 1 as an initial value and reduce the value of k by 0.1 every 10,000 hours of the total conduction time. Note that the total conduction time may be calculated by storing the operating times in the memory 60 from the start of use of the laser diode and adding the operating times. Further, it is also possible to separately store the total conduction time in the memory 60.

Further, another equation for calculating the estimated lifetime $\tau$ at step 211 for estimating the lifetime of the laser diode is shown below.

Assume that the initial value of the current supplied to the laser diode when reaching the rated output of the laser oscillator 100 according to the present invention at the time of start of use of the laser diode is $I_{opo}$. After this, it is possible to define the operating time until the value of the supplied current required for reaching the rated output multiplied with a predetermined multiple of $I_{opo}$ becomes necessary as the lifetime of the laser diode. The multiple can by experience be made 1.2 in a laser diode such as used for the pump light source of a solid state laser where the output is large to a certain extent and the threshold value current becomes over 100 mA *(Semiconductor Lasers* and *Their Applications,* p. 102, Yonezu Hiroo ed., Kogakusha, 1986). Therefore, the ratio r (= $I/I_{opo}$) between the value of the current I supplied to the laser diode at the time of reaching the rated output at the time of estimation of the lifetime of the laser diode and the initial value $I_{opo}$ of the value of the supplied current is calculated. Further, the estimated lifetime $\tau$ is found by the following equation (3) from the ratio r, the multiple (1.2), and the total conduction time T from the time of start of use of the laser diode:

[Equation 3]

$$\tau = \frac{(1.2 - 1.0)}{(I/I_{opo} - 1.0)} T \qquad (3)$$

When estimating the lifetime based on equation (3), the memory 60 has to store the total conduction time T and the initial value $I_{opo}$ of the current supplied to the laser diode. Note that the total conduction time T is calculated by designating the state of start of use of the laser diode as "0" and adding the time from when an instruction for turning on the laser oscillator is received by the processor 50 to when an instruction for turning the laser oscillator 100 off is received at the time of each operation. The calculated total conduction time T is used to update the value of the total conduction time T stored in the memory 60 before the power of the laser oscillator 100 is turned off. Further, the initial value $I_{opo}$ of the current supplied to the laser diode is measured as the value of the current supplied to the laser diode when the laser oscillator 100 reaches the rated output in the routine for calibration at the time of start of use of the laser diode (that is, right after replacement) and is stored in the memory 60.

Note that the laser diode used for the pump light source 10 changes in output intensity of the pump light according to the temperature. However, in the laser oscillator according to the present invention 100, the chiller 90 is used to keep the temperature of the pump light source 10 constant, so there is no need to consider the temperature in the estimation of the lifetime.

As an example, the case of use of an AlGaAs laser diode with a maximum rated current of 1.5A for the pump light source 10 will be explained. Further, assume that the lifetime is estimated every 1000 hours of cumulative operating time. Assume that at the time of start of use of the laser diode, the current supplied to the laser diode when reaching the rated output by the pulse system of the laser oscillator 100 according to the present invention is 1.0A. When the laser diode starts to deteriorate after the start of use of the laser oscillator 100, the amount of current supplied to the laser diode in order for the laser oscillator 100 to output the rated output laser light, that is, in order for the pump light emitted by the laser diode to become a predetermined intensity, increases. When the current I supplied to the laser diode becomes 1.05A at a certain time of estimation of the lifetime and the value of the current $I^{-m}$ supplied at the time of start of calculation of the cumulative operating time where the cumulative operating time T(m)=1000 at the time of estimation of the lifetime is 1.0A, from equation (1), the estimated lifetime $\tau$ becomes 9000 hours. Further, when the current I supplied to the laser diode is 1.15A at the time of estimation of the lifetime after further continued use and value of the current $I^{-m}$ supplied at the time of start of calculation of the cumulative operating time where the cumulative operating time $T(m)=1000$ at the time of estimation of the lifetime is 1.05A, from equation (1), the estimated lifetime $\tau$ becomes 3500 hours.

In this way, it is learned that as the amount of increase of the value of the supplied current becomes larger, the estimated lifetime becomes shorter - which matches with the general characteristics of a laser diode. Further, when a considerable total conduction time from the start of use of the laser diode elapses, for example, when the total conduction time from the start of use exceeds 50000 hours, use of equation (2) rather than equation (1) enables the accuracy of estimation of the lifetime to be improved. In the above example, if using equation (2) designating k as 0.5, when I = 1.05A and $I^{-m}$ = 1.0A, the estimated lifetime $\tau$ becomes 3000 hours, while when I = 1.15A and $I^{-m}$ = 1.05A, it becomes 1870 hours.

Note that separate conditions may be set for the type of the laser diode used for the pump light source, the interval for estimation of the lifetime, etc. as explained above.

The lifetime $\tau$ estimated above sometimes will be a negative value or an extremely large value due to measurement error of the value of the supplied current etc. when the deterioration of the pump light source 10 is minor. Therefore, the calculated estimated lifetime $\tau$ and a preset maximum value $\tau_{max}$ of the lifetime (in this embodiment, 100,000 hours) are compared (step 213). When the estimated lifetime $\tau$ is that maximum value $\tau_{max}$ or more or when the calculated estimated lifetime $\tau$ is a negative value, the calculated lifetime is replaced by the maximum value $\tau_{max}$ as the estimated lifetime (step 214).

The processor 50, when calculating the estimated lifetime $\tau$, compares the threshold value $\tau_{worn}$ showing that the laser diode has to be replaced or the replacement time is near (for example, 2000 hours) and the calculated estimated lifetime $\tau$ (step 215). When the estimated lifetime $\tau$ is the threshold value $\tau_{worn}$ or less, the processor 50 sets warning information (step 216).

Next, the estimated lifetime $\tau$ is displayed on the display 70 (step 217). Further, when warning information is set, the display 70 displays along with the estimated lifetime $\tau$ a warning showing that the remaining lifetime of the pump light source 10 is short. This warning may be performed by displaying the numerical value of the estimated lifetime $\tau$ on the display 70 by a color different from normal (for example, displaying a short remaining lifetime in red as compared with the usual green). Further, the display of the estimated lifetime $\tau$ may be made to blink on and off or a sound given off for the warning.

Finally, when a signal to turn the power off is sent from the operating panel to the processor 50, the processor 50 updates the operating time (step 219). That is, it shifts the previous operating times $T_1$, $T_2$,..., Tq one place each to $T_2$, $T_3$,..., $T_{q+l}$ and newly designates the time from when the processor 50 receives a signal to turn on the power to when it receives a signal to turn off the power in the current operation as $T_1$. Similarly, for the value of the supplied current each time as well, it shifts the previous values of the supplied current $I^{-1}$, $I^{-2}$,..., $I^{-q}$ one place each to $I^{-2}$, $I^{-3}$,..., $I^{-(q+1)}$ and newly designates the current value at the current operation as $I^{-1}$. The updated measurement value $I^{-1}$ of the supplied current is made the measurement value of the supplied current held at the time when a signal for turning off the power is received by the processor 50. As an alternative, it is also possible to temporarily store the measurement value of the supplied current at the time when the laser output is judged stable in a cache memory provided in the processor 50 and call it up at the time of updating and make it $I^{-1}$. The updated operating time and value of the supplied current are sent to the memory 60. The memory 60 then stores these values.

As explained above, according to the present invention, it is possible to have a power sensor receive the laser light emitted by the laser oscillator itself without measuring the pump light emitted by the pump light source and to accurately measure the lifetime of the pump light source by monitoring the value of the current supplied by the power source to the pump light source.

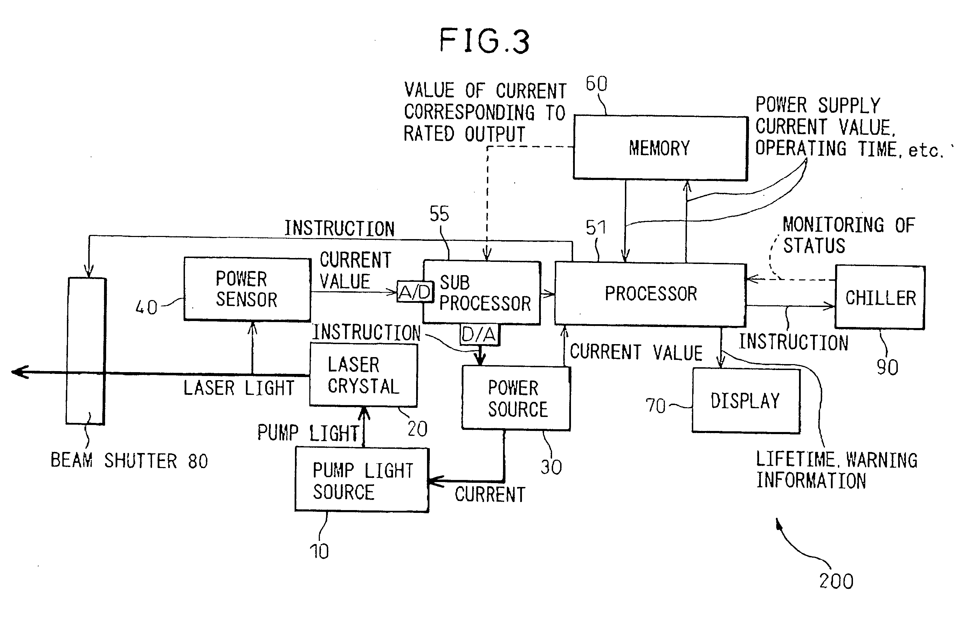

FIG. 3 is a view of the configuration of a laser oscillator according to a second embodiment of the present invention.

Parts similar to FIG. 1 are assigned the same notations. The configuration shown in FIG. 3 differs from the configuration shown in FIG. 1 in that, in the configuration shown in FIG. 3, a sub processor 55 is separately provided for independently handling the functions of the feedback loop for stabilizing the output laser light in the functions of the processor 50 shown in FIG. 1.

The sub processor 55 may be a processing unit built into the laser unit or may be an external processing unit such as a personal computer designed to be able to communicate with the laser unit and the processor 51. Further, the sub processor 55 may be configured as a circuit integral with the laser light current measurement circuit of the power sensor 40. In this configuration, when the sub processor 55 receives an instruction to turn on the power from the processor 51, it issues an instruction to the power source 30 to start the supply of current. Further, the sub processor 55 receives from the power sensor 40 the value of the laser light current $I_o$ corresponding to the output of the laser light and compares this with the value of the current $I_F$ corresponding to the rated output. When the result is that the measurement value $I_o$ is below the value of the current $I_F$ corresponding to the rated output, the sub processor 55 sends the power source 30 an instruction to increase the supplied current. Conversely, when it is over the value of the current $I_F$ corresponding to the rated output, the sub processor 55 sends the power source 30 an instruction to reduce the supplied current. Further, when the measurement value matches with the value of the current $I_F$ corresponding to the rated output, the sub processor 55 sends the power source 30 an instruction to maintain the supplied current as it is. Further, when receiving an instruction to turn off the power from the processor 51, it sends the power source 30 an instruction to stop the supplied current.

By configuring the invention in this way, the feedback cycle relating to the output of the laser light and the current supplied to the pump light source 10 becomes shorter, and the output stability of the laser can be improved over the configuration shown in FIG. 1. In this configuration as well, the processor 51 can monitor the measurement value of the current supplied by the power source 30 to the pump light source 10 to estimate the lifetime of the pump light source 10 in the same way as the example of configuration shown in FIG. 1. In this case, the judgment as to if the intensity of the output laser light is stable is performed by the sub processor 55. When the output is stable, the sub processor 55 can be designed to notify the processor 51 that the output of the laser light is stable. Alternatively, the processor 51 can judge this by monitoring the value of the current I supplied by the power source 30 to the pump light source 10. In this case, this judgment can be performed based on whether the value of the current I remains in a predetermined range for a predetermined period.

Further, the lifetime estimating routine can be executed by a routine similar to the flow charts shown in FIG. 2A and FIG. 2B. However, there is a difference from the configuration shown in FIG. 1 in the point that the adjustment of the current supplied to the pump light source at step 208 is performed by solely the sub processor 55.

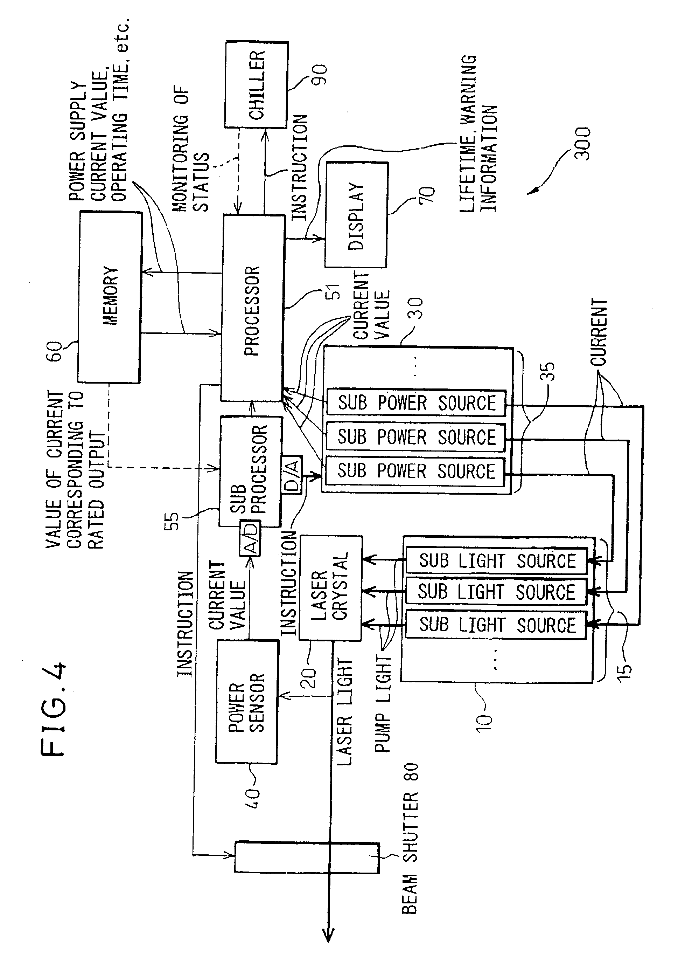

FIG. 4 shows an example of the configuration of a laser oscillator 300 according to a third embodiment of the present invention.

In the same way as above, parts similar to the parts shown in FIG. 1 or FIG. 3 are assigned the same notations. The configuration shown in FIG. 4 differs from the configuration shown in FIG. 3 in that, in the configuration shown in FIG. 4, the pump light source 10 has a plurality of sub light sources 15 and the power source 30 has a plurality of sub power sources 35.

In this example of the configuration, the pump light source 10 is comprised of a plurality of laser diodes or a plurality of laser diode arrays, that is, a plurality of sub light sources 15. For example, each sub light source 15 is an individual laser diode, and a plurality of these laser diodes are arranged in for example a single row to form a laser diode array. The pump light source 10 may be designed to provide a plurality of laser diode arrays as the sub light sources 15, arrange the laser diode arrays around the laser crystal 20, and emit light to the laser crystal 20 from a plurality of directions. In this case, the power source 30 is comprised of a plurality of sub power sources 35 supplying power to the individual sub light sources (laser diodes or laser diode arrays). Each sub power source 35 is provided with an ammeter able to measure the value of the current supplied to the corresponding sub light source 15. Further, the measurement value of the supplied current measured by each ammeter is sent to the processor 50. When there are N number of sub power sources 35, the processor 50 can use the measurement values $I_1, I_2, ..., I_N$ of the supplied current of the sub power sources 35 when the laser output of the laser oscillator according to the present invention 300 reaches the rated output to estimate the lifetime of each laser diode or laser diode array used for the pump light source 10 in the same way as the examples of the configuration shown in FIG. 1 and FIG. 3. The lifetime of each sub light source 15 which a sub power source 35 supplies current to is estimated based on the following equation:

[Equation 4]

$$\tau_n = \frac{(I_{max} - I_n)}{(I_n - I_n^{-m})} \, T(m) \qquad\qquad (4)$$

where, In is the measurement value of the current supplied by the n-th sub power source when reaching the rated output, and $I_n^{-m}$ is the measurement value of the current when reaching the rated output supplied to the corresponding sub light source 15 by the n-th sub power source at the time of estimation of the lifetime m times before. Further, in the same way as the example of configuration shown in FIG. 1 and FIG. 3, the following equation may be used to estimate the lifetime for each of the sub light sources 15.

[Equation 5]

$$\tau_n = \frac{(I_{max} - I_n)^k}{(I_n - I_n^{-m})^k} T(m) \qquad (5)$$

Here, k, in the same way as in equation (2), is by experience preferably 0.5 to less than 1.

Note that it is also possible to use an equation similar to equation (3) to estimate the lifetime.

In the case of this embodiment, the memory 60 stores the values of the current supplied by the sub power sources 35 at the time of reaching the rated output at the time of operation or the time of calibration. Further, the information called up by the processor 51 and the information instructed to be updated by the processor 51 are the values of the current supplied to the sub power sources 35 at the different times of operation. The laser crystal 20, power sensor 40, etc. are the same in configuration as in FIG. 1 and FIG. 3.

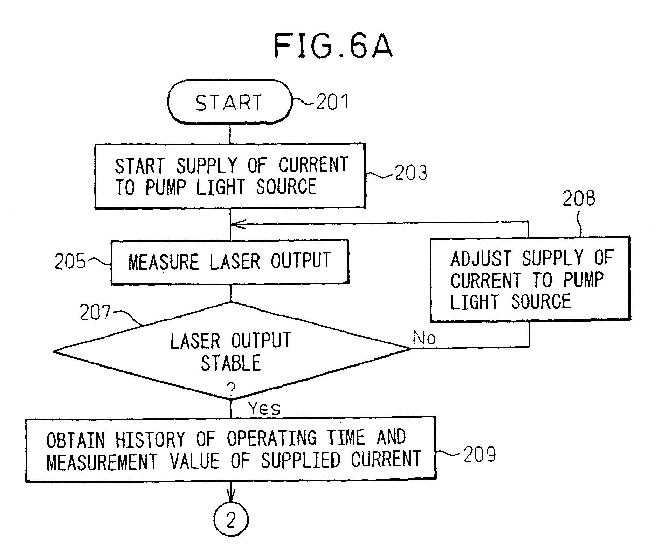

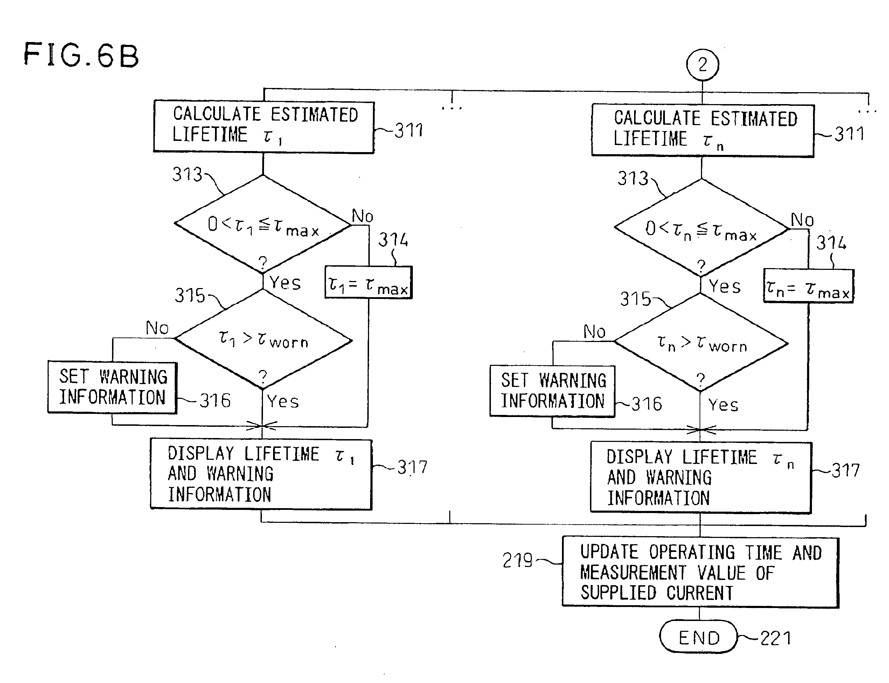

Further, FIG. 6A and FIG. 6B show flow charts of the lifetime estimating routine in a third embodiment. Steps for executing the same routines as the flow charts shown in FIG. 2A and FIG. 2B are assigned the same notations as in FIG. 2A and FIG. 2B. The flow charts of FIG. 6A and FIG. 6B differ from the flow charts of FIG. 2A and FIG. 2B in that, in FIG. 2A and FIG. 2B, the estimated lifetime was calculated for a single pump light source 10, while in FIG. 6A and FIG. 6B, the estimated lifetime is calculated for each of the sub light sources 15.

That is, the estimated lifetime is calculated for each sub light source 15 (step 311). Further, each calculated estimated lifetime is compared with a preset maximum value $\tau_{max}$ of the lifetime (in this embodiment, 100,000 hours) (step 313). When the estimated lifetime is the maximum value $\tau_{max}$ or more or when the calculated estimated lifetime is a negative value, the calculated lifetime is replaced with the maximum value $\tau_{max}$ as the estimated lifetime (step 314). Further, each calculated estimated lifetime is compared with a threshold value $\tau_{worn}$ (for example, 2000 hours) showing that the laser diode has to be replaced or the replacement time is near (step 315). When the estimated lifetime $\tau$ is the threshold value $\tau_{worn}$ or less, warning information is set (step 316).

As an example, the case of using three laser diode arrays each comprising 500 AlGaAs laser diodes as the pump light source 10 will be explained. The power of the laser oscillator 300 is turned on (step 201), then the sub power sources 35 supply current to the sub light sources 15 of the pump light source 10 by the pulse system (step 203). Part of the laser light emitted from the laser crystal 20 is guided to the power sensor 40 where the intensity of the laser light is measured (step 205). After this, it is judged if the intensity of the laser light is stable (step 207). When it is judged not to be stable, the supplied current is adjusted (step 208). On the other hand, when it is judged that the intensity of the laser light is stable, the processor 51 obtains the operating time of the laser oscillator 300, the values of the current supplied to the sub power sources 35, etc. from the memory 60 (step 209). Further, the estimated lifetime $\tau_n$ (n = 1,2,3) is calculated for each of the sub light sources 15 (in the example shown here, the laser diode arrays) (step 311).

Here, assume that the maximum rated current of the laser diode array is 40.0A. Further, the lifetime is estimated every 1000 hours of the cumulative operating time. At the start of use of each laser diode array, assume that the current supplied to the laser diode array when reaching the rated output by the pulse system in the laser oscillator according to the present invention 300 is 30.0A. In this embodiment, as the parameters of the pulse oscillation, use was made of a duty ratio of 80% and a frequency of 2Hz, but countless combinations of the duty ratio and frequency may be considered. For one among the laser diode arrays, when the current $I_n$ supplied to the laser diode array at the time of estimation of the lifetime is 30.5A and the value of the current supplied at the start of calculation of the cumulative operating time where the cumulative operating time T(m)=1000 at the time of estimation of the lifetime is 30.0A, from equation (4), the estimated lifetime $\tau_n$ becomes 19000 hours. Further, when, at the time of estimation of the lifetime after continued use the current In supplied to the laser diode array is 31.5A and the value $I_n^{-m}$ of the current supplied at a time in the past corresponding to the cumulative operating time T(m)=1000 is 30.5A, from equation (4), the estimated lifetime $\tau_n$ becomes 8500 hours. In this case as well, as the amount of increase of the value of the supplied current becomes larger, the estimated lifetime becomes shorter and results of estimation of lifetime matching with the general characteristics cf a laser diode are obtained. Further, when a considerable total conduction time has elapsed from the start of use of the laser diode array, for example, when the total conduction time from the start of use exceeds 50000 hours, using equation (5) rather than equation (4) enables improvement of the accuracy of estimation of the lifetime. In this example, if using equation (5) assuming that k = 0.5, when $I_n$ = 30.5A and $I_n^{-m}$ = 30.0A, the estimated lifetime $\tau_n$ becomes about 4360 hours, while when $I_n$ = 31.5A and $I_n^{-m}$ = 30.5A, it becomes about 2920 hours.

When the estimated lifetime $\tau_n$ is calculated, in the same way as the flow charts shown in FIG. 2A and FIG. 2B, this is compared with the maximum value $\tau_{max}$ of the lifetime (step 313). When over $\tau_{max}$, this is replaced by $\tau_{max}$ (step 314). Further, it is judged if the replacement time is near for each of the sub light sources 15 (step 315). When it is judged that the replacement time is near, warning information is set (step 316). After this, the estimated lifetime $\tau_n$ and warning information are displayed (step 317). Finally, the operating time of the laser oscillator and the value of the current supplied to each sub power source 35 are updated (step 219).

Note that in the above embodiments, the processor 50 (or processor 51) obtained the value of the current from the power source 30 (including sub power sources 35) to estimate the lifetime of the pump light source 10, but instead of the value of the current, it is also possible to obtain the value of the voltage supplied to the pump light source 10. Even when obtaining the value of the voltage, if using the resistance value of the pump light source itself to convert this to the value of current value, it becomes possible to similarly use equation (1) to equation (5) to estimate the lifetime. Similarly, the value of current obtained from the power sensor 40 may also be made the value of voltage. Further, instead of the value of the current supplied from the power source 30 (including sub power source 35) to the pump light source 10, the value of the voltage supplied to the pump light source 10 may be stored in the memory 60.

Further, in the above explanation of the lifetime estimating routine, the case of operating the laser oscillator by the pulse system was explained, but the lifetime of the pump light source can similarly be estimated even for the case of operating the laser oscillator by the continuous system.

As explained above, according to the present invention, it is possible to have a power sensor receive the laser light emitted by the laser oscillator itself without measuring the pump light emitted by the pump light source, to measure the lifetime of the pump light source by monitoring the value of the current supplied by the power source to the pump light source, and to estimate the lifetime of the pump light source by a simple configuration without an increase in the number of parts even if using a plurality of laser diode for the pump light source.

While the invention has been described with reference to specific embodiments chosen for purpose of illustration, it should be apparent that numerous modifications could be made thereto by those skilled in the art without departing from the basic concept and scope of the invention.

**Claims**

1. A laser oscillator provided with
   a pump light source,
   a power source for supplying current to the pump light source,
   a laser crystal outputting laser light by pump light emitted from the pump light source,
   a power sensor receiving the laser light generated by the laser crystal and outputting a signal corresponding to the intensity of that laser light,
   a memory storing the operating time of the laser oscillator, and
   a processor using the value of the current supplied by the power source to the pump light source and the operating time stored in the memory to estimate the lifetime of the pump light source.

2. A laser oscillator as set forth in claim 1, wherein the processor preferably judges whether the signal output from the power sensor satisfies a predetermined condition and estimates the lifetime of the pump light source when satisfying the predetermined condition.

3. A laser oscillator as set forth in claim 1, wherein the oscillator further has a sub processor which judges whether the signal output from the power sensor satisfies a predetermined condition, and the processor estimates the lifetime of the pump light source when notified by the sub processor of a judgment of the condition being satisfied.

4. A laser oscillator as set forth in claim 2 or 3, wherein
   said memory stores the value of the current supplied by said power source to said pump light source at the time of estimation of the lifetime, and
   the processor estimates the lifetime by finding the estimated lifetime τ from the relation

$$\tau = \left( (I_{max} - I)/(I - I^{-m}) \right)^{k} T(m),$$

   wherein k is a real number of 0.5 to 1.0 using the value of the current I supplied by the power source to the pump light source when the signal output from the power sensor is judged to satisfy said predetermined condition, a predetermined cumulative operating time $T(m)$ found from the operating time stored in the memory, a value of the current $I^{-m}$ supplied to the pump light source at the time of estimation of the lifetime determined based on said cumulative operating time $T(m)$ obtained from the memory, and the value of the maximum rated current $I_{max}$ of the pump light source.

**5.** A laser oscillator as set forth in claim 2 or 3, wherein the pump light source has a plurality of sub light sources, and the power source has a plurality of sub power sources supplying current to the plurality of sub light sources.

**6.** A laser oscillator as set forth in claim 5, wherein
said memory stores the values of the currents supplied by the sub power sources to the sub light sources at the different times of estimation of the lifetime, and
the processor estimates the lifetime when judging that the signal output from the power sensor satisfies said predetermined condition by using the value of the current $I_n$ supplied by any sub power source to a sub light source, a predetermined cumulative operating time $T(m)$ found from the operating times stored in the memory, the value of the current $I_n^{-m}$ supplied to the sub light sources at the time of estimation of the lifetime determined based on the cumulative operating time $T(m)$ obtained from the memory, and the value of the maximum rated current $I_{max}$ of the pump light source to find the estimated lifetime $\tau_n$ of the sub light source from the relation:

$$\tau_n = ((I_{max} - I_n) / (I - I_n^{-m}))^k \; T(m)$$

where k is a real number from 0.5 to 1.0.

**7.** A laser oscillator as set forth in any one of claims 2 to 6, wherein said predetermined condition is that, both when the method of output of the laser light is continuous or pulse oscillation, the fluctuation of the signal output by the power sensor remains within a predetermined range for a predetermined period.

**8.** A laser oscillator as set forth in any one of claims 1 to 7, further having a display which displays the estimated lifetime of the pump light source estimated by the processor and displays a warning when the estimated lifetime is a predetermined replacement warning standard or less.

**9.** A method of estimation of the lifetime of a pump light source of a laser oscillator having a pump light source, a power source supplying current to the pump light source, a laser crystal outputting laser light by pump light emitted from the pump light source, a power sensor receiving laser light generated from the laser crystal and outputting a signal corresponding to the intensity of that laser light, a memory storing the operating time, and a processor estimating the lifetime of the pump light source, including
a step of adjusting the laser light generated by the laser oscillator to a predetermined intensity,
a step of measuring the value of the current supplied by the power source to the pump light source when the laser light generated by the laser oscillator is adjusted to the predetermined intensity, and
a step of estimating the lifetime of the pump light source based on the current value and the operating time of the laser oscillator.

**10.** A method of estimation of the lifetime of the pump light source of a laser oscillator as set forth in claim 9, wherein
said memory is designed to further store the value of the current measured at the step of measuring the current value,
the step of measuring the current value measures the value of the current I supplied by the power source to the pump light source when the laser light generated by the laser oscillator is adjusted to a predetermined intensity, and
the step of estimating the lifetime finds the cumulative operating time $T(m)$ showing the predetermined period during which the laser oscillator was operated from the operating times stored in the memory and uses the value of the current I, the value of the current $I^{-m}$ supplied by the power source to the pump light source measured when the laser light generated by the laser oscillator is adjusted to the predetermined intensity in an operating time of the laser oscillator specified based on the cumulative operating time $T(m)$ stored in the memory, and the value of the maximum rated current $I_{max}$ of the pump light source to find the estimated lifetime $\tau$ from the relation

$$\tau = ((I_{max} - I) / (I - I^{-m}))^k \; T(m)$$

where, k is a real value of 0.5 to 1.0

**11.** A method of estimation of the lifetime of the pump light source of a laser oscillator as set forth in claim 9 or 10, wherein
in the step of adjusting to the predetermined intensity, the method of output of the laser is pulse output, and
the step of measuring the current value measures the value of the current when the fluctuation of the signal output by the power sensor remains within a predetermined range for a predetermined period.

# FIG.1

POWER SUPPLY
CURRENT VALUE,
OPERATING TIME, etc.

MEMORY 60

INSTRUCTION

CURRENT
VALUE

MONITORING OF
STATUS

50

POWER
SENSOR 40

A/D

PROCESSOR

CHILLER 90

INSTRUCTION

D/A

INSTRUCTION

LASER
CRYSTAL 20

LASER LIGHT

POWER
SOURCE 30

DISPLAY 70

BEAM SHUTTER 80

PUMP LIGHT

PUMP LIGHT
SOURCE 10

CURRENT

CURRENT VALUE

LIFETIME, WARNING
INFORMATION

100

EP 1 681 750 A1

# FIG.2A

```
        ( START )──201
            │
            ▼
┌────────────────────────┐
│ START SUPPLY OF CURRENT │──203
│ TO PUMP LIGHT SOURCE    │
└────────────────────────┘
            │
            ▼ ◄─────────────────────────────────────┐
   ┌──────────────────────┐         ┌──────────────────────┐
   │ MEASURE LASER OUTPUT │──205    │  ADJUST SUPPLY OF     │
   └──────────────────────┘         │  CURRENT TO PUMP      │
            │                  208──│  LIGHT SOURCE         │
            ▼ ──207                 └──────────────────────┘
      ◇─────────────────◇  No              ▲
      │  LASER OUTPUT   │───────────────────┘
      │    STABLE       │
      │      ?          │
      ◇─────────────────◇
            │ Yes
            ▼
┌─────────────────────────────────────────┐
│ OBTAIN HISTORY OF OPERATING TIME AND      │──209
│ MEASUREMENT VALUE OF SUPPLIED CURRENT     │
└─────────────────────────────────────────┘
            │
            ▼
┌─────────────────────────────────────────┐
│ CALCULATE ESTIMATED LIFETIME $\tau$       │──211
└─────────────────────────────────────────┘
            │
            ▼
          ( 1 )
```

# FIG.2B

① 

$0 < \tau \leqq \tau_{max}$ ? $\overset{213}{\phantom{x}}$

No → $\tau = \tau_{max}$ $\overset{214}{\phantom{x}}$

Yes

$\tau > \tau_{worn}$ ? $\overset{215}{\phantom{x}}$

No → SET WARNING INFORMATION $\overset{216}{\phantom{x}}$

Yes

DISPLAY LIFETIME $\tau$ AND WARNING INFORMATION $\overset{217}{\phantom{x}}$

UPDATE OPERATING TIME AND MEASUREMENT VALUE OF SUPPLIED CURRENT $\overset{219}{\phantom{x}}$

END $\overset{221}{\phantom{x}}$

# FIG.3

VALUE OF CURRENT CORRESPONDING TO RATED OUTPUT

60

MEMORY

POWER SUPPLY CURRENT VALUE, OPERATING TIME, etc.

MONITORING OF STATUS

INSTRUCTION

55

51

CURRENT VALUE

POWER SENSOR

40

A/D

SUB PROCESSOR

PROCESSOR

CHILLER

INSTRUCTION

D/A

90

LASER LIGHT

LASER CRYSTAL

CURRENT VALUE

INSTRUCTION

POWER SOURCE

DISPLAY

70

BEAM SHUTTER 80

PUMP LIGHT

20

30

PUMP LIGHT SOURCE

CURRENT

LIFETIME, WARNING INFORMATION

10

200

EP 1 681 750 A1

# FIG.4

VALUE OF CURRENT CORRESPONDING TO RATED OUTPUT

60

MEMORY

POWER SUPPLY CURRENT VALUE, OPERATING TIME, etc.

INSTRUCTION

55

MONITORING OF STATUS

POWER SENSOR — 40

CURRENT VALUE

A/D

SUB PROCESSOR

PROCESSOR

CHILLER

90

INSTRUCTION

D/A

51

LASER CRYSTAL — 20

CURRENT VALUE

DISPLAY

70

LASER LIGHT

PUMP LIGHT

SUB POWER SOURCE

SUB POWER SOURCE

SUB POWER SOURCE

...

30

LIFETIME, WARNING INFORMATION

BEAM SHUTTER 80

SUB LIGHT SOURCE

SUB LIGHT SOURCE

SUB LIGHT SOURCE

...

10

35

300

15

CURRENT

EP 1 681 750 A1

# FIG.5

EP 1 681 750 A1

# FIG.6A

START ~201

START SUPPLY OF CURRENT TO PUMP LIGHT SOURCE ~203

205~ MEASURE LASER OUTPUT

ADJUST SUPPLY OF CURRENT TO PUMP LIGHT SOURCE 208

207~ LASER OUTPUT STABLE ? No

Yes

OBTAIN HISTORY OF OPERATING TIME AND MEASUREMENT VALUE OF SUPPLIED CURRENT ~209

2

# FIG.6B

CALCULATE ESTIMATED LIFETIME $\tau_1$ ~311

313 — $0 < \tau_1 \leqq \tau_{max}$ ?  No → 314 $\tau_1 = \tau_{max}$

Yes

315 — $\tau_1 > \tau_{worn}$ ?

No → SET WARNING INFORMATION ~316

Yes

DISPLAY LIFETIME $\tau_1$ AND WARNING INFORMATION ~317

CALCULATE ESTIMATED LIFETIME $\tau_n$ ~311

313 — $0 < \tau_n \leqq \tau_{max}$ ?  No → 314 $\tau_n = \tau_{max}$

Yes

315 — $\tau_n > \tau_{worn}$ ?

No → SET WARNING INFORMATION ~316

Yes

DISPLAY LIFETIME $\tau_n$ AND WARNING INFORMATION ~317

219 — UPDATE OPERATING TIME AND MEASUREMENT VALUE OF SUPPLIED CURRENT

END ~221

EP 1 681 750 A1

**European Patent Office**

**EUROPEAN SEARCH REPORT**

Application Number

EP 06 00 0490

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | EP 0 997 224 A (MIYACHI TECHNOS CORPORATION) 3 May 2000 (2000-05-03) | 1-3,5,8, 9 | H01S3/0941 H01S3/06 H01S3/102 |
| Y | * paragraphs [0028] - [0039], [0061] - [0069], [0076] - [0084]; figures 2,3,10-12 * | 4,6,7, 10,11 | |
| X | PATENT ABSTRACTS OF JAPAN vol. 2003, no. 12, 5 December 2003 (2003-12-05) -& JP 2004 259751 A (NEC CORP), 16 September 2004 (2004-09-16) | 1,2,9 | |
| Y | * figures 1-4 and paragraphs [0005] - [0007] and [0008] - [0012] of the computer-generated English translation of JP-A-2004 259751 * * abstract * | 4,6,10 | |
| Y | US 2002/006146 A1 (MCMINN THEODORE S ET AL) 17 January 2002 (2002-01-17) | 4,6,10 | |
| A | * paragraphs [0029] - [0039], [0042], [0043], [0057] - [0061]; figures 2,5 * | 1,2,5,9 | |
| | | | TECHNICAL FIELDS SEARCHED (IPC) |
| Y | EP 0 543 110 A (ROCKWELL INTERNATIONAL CORPORATION) 26 May 1993 (1993-05-26) * column 1, lines 5-20; figures 1,2 * * column 2, line 25 - column 3, line 50 * | 7,11 | H01S |
| Y | MIZUISHI K-I ET AL: "RELIABILITY OF INGAASP/INP BURIED HETEROSTRUCTURE LASERS" JAPANESE JOURNAL OF APPLIED PHYSICS, JAPAN SOCIETY OF APPLIED PHYSICS, TOKYO, JP, vol. 21, no. SUPPL 1, 1982, pages 359-364, XP000712275 ISSN: 0021-4922 * page 362 - page 363; figure 8 * | 7,11 | |

-/--

The present search report has been drawn up for all claims

| Place of search | Date of completion of the search | Examiner |
|---|---|---|
| Munich | 1 March 2006 | Laenen, R |

**European Patent Office**

**EUROPEAN SEARCH REPORT**

Application Number

EP 06 00 0490

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2002/126724 A1 (TSUNEKANE MASAKI ET AL) 12 September 2002 (2002-09-12) * paragraphs [0123] - [0132], [0138]; figure 14 * ----- | 1,2,9 | |
| A | EP 0 512 541 A (FUJITSU LIMITED) 11 November 1992 (1992-11-11) * column 9, line 34 - column 12, line 4; figures 1,2 * ----- | 1,2,8,9 | |
| | | | TECHNICAL FIELDS SEARCHED (IPC) |

The present search report has been drawn up for all claims

| Place of search | Date of completion of the search | Examiner |
|---|---|---|
| Munich | 1 March 2006 | Laenen, R |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

    ...........................................................................

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 06 00 0490

This annex lists the patent family members relating to the patent documents cited in the above-mentioned European search report.
The members are as contained in the European Patent Office EDP file on
The European Patent Office is in no way liable for these particulars which are merely given for the purpose of information.

01-03-2006

| Patent document cited in search report | | Publication date | Patent family member(s) | | Publication date |
|---|---|---|---|---|---|
| EP 0997224 | A | 03-05-2000 | CN | 1253867 A | 24-05-2000 |
| | | | DE | 69908737 D1 | 17-07-2003 |
| | | | DE | 69908737 T2 | 29-04-2004 |
| | | | JP | 2000135579 A | 16-05-2000 |
| | | | KR | 2000029336 A | 25-05-2000 |
| | | | US | 6355905 B1 | 12-03-2002 |
| JP 2004259751 | A | 16-09-2004 | NONE | | |
| US 2002006146 | A1 | 17-01-2002 | NONE | | |
| EP 0543110 | A | 26-05-1993 | DE | 69210550 D1 | 13-06-1996 |
| | | | DE | 69210550 T2 | 19-12-1996 |
| | | | JP | 6216443 A | 05-08-1994 |
| | | | US | 5199037 A | 30-03-1993 |
| US 2002126724 | A1 | 12-09-2002 | EP | 1239557 A2 | 11-09-2002 |
| | | | JP | 2002270926 A | 20-09-2002 |
| EP 0512541 | A | 11-11-1992 | DE | 69213811 D1 | 24-10-1996 |
| | | | DE | 69213811 T2 | 30-01-1997 |
| | | | DE | 69230734 D1 | 06-04-2000 |
| | | | DE | 69230734 T2 | 29-06-2000 |
| | | | JP | 2546080 B2 | 23-10-1996 |
| | | | JP | 4334078 A | 20-11-1992 |
| | | | KR | 9606211 B1 | 09-05-1996 |
| | | | US | 5334826 A | 02-08-1994 |

EPO FORM P0459

For more details about this annex : see Official Journal of the European Patent Office, No. 12/82